# FASCICULE DE BREVET EUROPEEN

(11) **EP 2 965 317 B1**
(45) Date de publication et mention de la délivrance du brevet: **29.07.2020**
(21) Numéro de dépôt: 14713154.4
(22) Date de dépôt: 18.02.2014
(51) Int. Cl.: G11C 7/24, G11C 8/20, G11C 11/4078, G11C 16/22

(54) **MÉMOIRE COMPRENANT UN CIRCUIT POUR DÉTECTER UNE IMPULSION TRANSITOIRE SUR UNE LIGNE DE LA MÉMOIRE**
SPEICHER MIT SCHALTUNG ZUR DETEKTION EINES TRANSIENTEN IMPULSES AUF EINER LEITUNG DES SPEICHERS
MEMORY COMPRISING A CIRCUIT FOR DETECTING A TRANSIENT PULSE ON A LINE OF THE MEMORY

(30) Priorité: 06.03.2013 FR 1352007
(43) Date de publication de la demande: 13.01.2016
(73) Titulaire: WISeKey Semiconductors, 13590 Meyreuil (FR)
(72) Inventeur: BOUZEKRI ALAMI, Salwa, F-13100 Aix En Provence (FR)
(74) Mandataire: Marchand, André
(86) Numéro de dépôt international: PCT/FR2014/050336
(87) Numéro de publication internationale: WO 2014/135758

(56) Documents cités:
- US-A- 4 812 675
- US-A- 4 812 675
- US-A1- 2008 137 455
- US-A1- 2008 137 455
- US-B1- 6 879 518
- US-B1- 6 879 518

## Description

La présente invention concerne une mémoire comprenant un circuit pour détecter une impulsion transitoire non autorisée sur une ligne de mots de la mémoire, et un procédé de détection d'une telle impulsion transitoire.

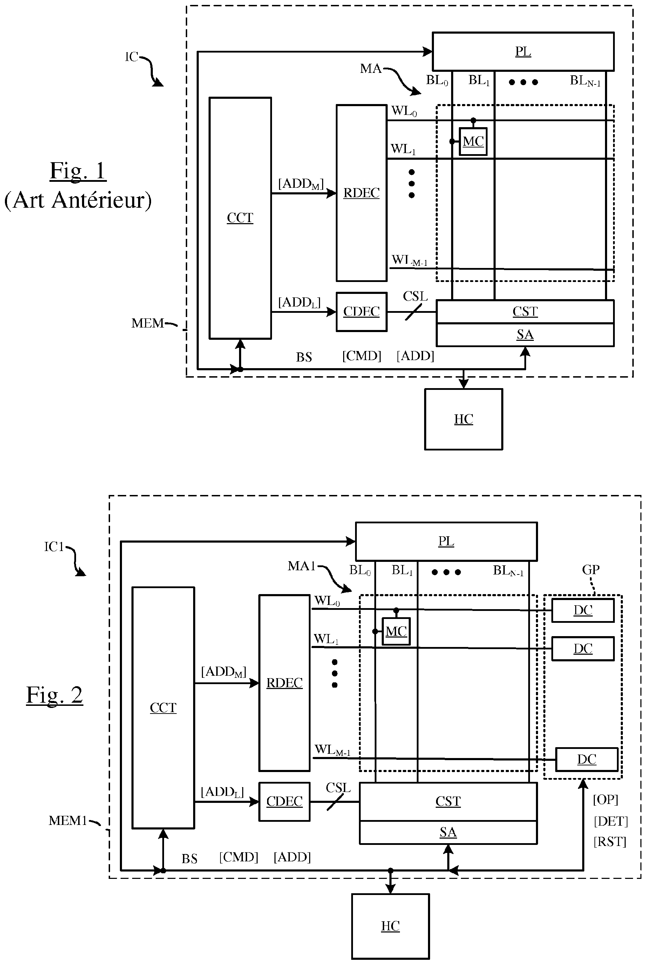

La figure 1 montre un circuit intégré IC comprenant une mémoire MEM et un processeur hôte HC. La mémoire MEM comprend un plan MA de cellules mémoire MC (une seule d'entre elles étant montrée), des lignes de mots WLₘ (WL₀ à WL_{M-1}), des lignes de bits BLₙ (BL₀ à BL_{N-1}), un décodeur de ligne RDEC, un décodeur de colonne CDEC, un groupe de verrous de programmation PL, un groupe de transistors de sélection de colonne CST, un groupe d'amplificateurs de lecture SA, et un circuit de commande CCT. Chaque cellule mémoire est connectée à une ligne de mots WLₘ et à une ligne de bits BLₙ. Les lignes de mots WLₘ ont une extrémité reliée au décodeur de ligne RDEC, et les lignes de bits BLₙ ont une extrémité reliée aux verrous de programmation PL et une autre extrémité reliée aux amplificateurs de lecture SA par l'intermédiaire des transistors CST. Ces derniers sont contrôlés par le décodeur de colonne CDEC par l'intermédiaire de lignes de sélection de colonne CSL. Le circuit de commande CCT est relié au processeur hôte HC, aux entrées des verrous de programmation PL, et aux sorties des amplificateurs de lecture SA via un bus BS. Le circuit de commande CCT reçoit des commandes de lecture, de programmation ou d'effacement CMD envoyées par le processeur hôte HC. De telles commandes comprennent des adresses ADD de cellules mémoire et peuvent comprendre des données à écrire. Les adresses peuvent être divisées en adresses de poids fort ADD_{M} et adresses de poids faible ADD_{L}. Le circuit de commande fournit l'adresse de poids fort ADD_{M} au décodeur de ligne et l'adresse de poids faible ADD_{L} au décodeur de colonne CDEC pour sélectionner les cellules mémoire. Pour réaliser une opération de lecture, de programmation ou d'effacement sur une ou plusieurs cellules mémoire sélectionnées, une valeur de tension, par exemple de 5 V ou plus, est appliquée à une ligne de mots WLₘ. Les lignes de mots non sélectionnées sont généralement connectées à la masse.

Un tel circuit intégré IC peut faire l'objet d'attaques visant à découvrir les données sensibles et/ou à influer sur les opérations en cours. Dans une attaque dite par injection de fautes, une source laser produit un faisceau laser ayant une longueur d'onde et une profondeur de pénétration contrôlées. Le faisceau laser est appliqué sur une zone spécifique du circuit pour générer des signaux électriques transitoires sans effet destructeur sur le circuit, de sorte que l'attaque est reproductible. Des sondes mises en contact avec le circuit permettant à un attaquant d'en déduire des données ou d'analyser une opération en cours.

En particulier, la mémoire MEM peut faire l'objet d'une attaque à l'entrée du décodeur de ligne RDEC ou à l'intérieur des circuits du décodeur de ligne contrôlant les lignes de mots. De ce fait, une impulsion transitoire, équivalente à un signal logique passant à la valeur de 1, peut apparaître sur une ou plusieurs lignes de mots qui ne sont pas sélectionnées, et déclencher une opération indésirable sur des cellules mémoire. Des données peuvent ainsi être programmées ou effacées de manière involontaire. Lorsque la mémoire est utilisée pour mémoriser des données importantes, telles que des clés d'identification, des codes, des données d'application, etc., il est souhaitable d'assurer l'intégrité des données écrites ou lues dans la mémoire. Il pourrait donc être souhaité de prévenir ce type d'attaque.

Des modes de réalisation de l'invention concernent une mémoire selon la revendication 1 et un procédé selon la revendication 11. Les revendications dépendantes 2-10 et 12-14 concernent des modes particuliers de réalisation de l'invention.

Des modes de réalisation d'une mémoire comprenant un circuit de détection d'impulsion transitoire selon l'invention et mettant en œuvre un procédé de détection d'impulsion transitoire selon l'invention seront décrits dans ce qui suit à titre non limitatif en relation avec les figures jointes, parmi lesquelles :
- la figure 1 précédemment décrite est une vue schématique d'une mémoire conventionnelle,
- la figure 2 est une vue schématique d'une mémoire comprenant un circuit de détection d'impulsion transitoire de l'invention,
- la figure 3 montre un mode de réalisation du circuit de détection d'impulsion transitoire de la figure 2,
- la figure 4 est un chronogramme illustrant une détection d'impulsion transitoire au moyen du circuit de détection de la figure 3,
- la figure 5 montre une variante du circuit de détection d'impulsion transitoire de la figure 3,
- la figure 6 est un chronogramme illustrant une détection d'impulsion transitoire au moyen du circuit de détection de la figure 5,
- la figure 7 montre une variante du circuit de détection d'impulsion transitoire de la figure 5,
- la figure 8 est un chronogramme illustrant une détection d'impulsion transitoire au moyen du circuit de la figure 7,
- la figure 9 montre un autre mode de réalisation d'un circuit de détection d'impulsion transitoire selon l'invention,
- la figure 10 montre une variante du circuit de détection de la figure 9,
- la figure 11 montre une variante du circuit de détection d'impulsion de la figure 10, et
- la figure 12 montre un autre mode de réalisation d'un circuit de détection d'impulsion transitoire selon l'invention.

La figure 2 montre un circuit intégré IC1 comprenant une mémoire MEM1 et un processeur hôte HC. La mémoire MEM peut être une mémoire EEPROM (effaçable et programmable électriquement), Flash, EPROM, OTP ("programmable une seule fois"), MTP ("programmable plusieurs fois"), ROM ("mémoire morte"), etc. Comme précédemment décrit en relation avec la figure 1, la mémoire MEM1 comprend un circuit de commande CCT, un plan MA1 de cellules mémoire MC (une seule d'entre elles étant montrée) comprenant des lignes de mots WLₘ (WL₀ à WL_{M-1}) et des lignes de bits BLₙ (BL₀ à BL_{N-1}), chaque cellule mémoire étant connectée à une ligne de mots WLₘ et à une ligne de bits BLₙ. La mémoire comprend également un décodeur de ligne RDEC, un décodeur de colonne CDEC, un groupe de verrous de programmation PL, un groupe de transistors de sélection de colonne CST, un groupe d'amplificateurs de lecture SA.

La mémoire comprend en outre un groupe GP de circuits de détection DC selon l'invention, pour détecter des impulsions transitoires non autorisées. Chaque ligne de mots WLₘ a une extrémité reliée au décodeur de ligne RDEC, et une autre extrémité reliée à l'un des circuits de détection d'impulsion transitoire DC. Le circuit de commande CCT est également relié au groupe GP de circuits de détection DC, et fournit à celui-ci un ou plusieurs signaux de fin d'opération OP et reçoit de celui-ci un ou plusieurs signaux de détection d'impulsion transitoire DET. Dans certains modes de réalisation de l'invention le processeur hôte fournit par ailleurs un signal de réinitialisation RST au groupe de circuits de détection DC.

Chaque circuit de détection DC est configuré pour détecter une impulsions transitoire sur la ligne de mots WL à laquelle il est relié, lorsque l'amplitude d'un signal en tension présent sur la ligne de mot présente un front descendant, c'est-à-dire passe d'une première valeur au-dessus d'un seuil de tension correspondant ici par convention à un "1" logique, à une seconde valeur nulle ou en dessous du seuil de tension, correspondant ici par convention à un "0" logique, pendant qu'une opération est en cours d'exécution sur une ou plusieurs cellules mémoire. Le signal de fin d'opération OP intervient comme un moyen de discrimination entre un front descendant non autorisé apparaissant pendant qu'une opération est en cours, et un front descendant autorisé apparaissant à la fin d'une opération. A cet effet le signal OP est mis à une première valeur logique pendant l'exécution d'une opération, cette valeur étant choisie ici égale à 0 par convention, et à une seconde valeur logique, ici 1, à la fin d'une opération. Pour faciliter la compréhension de modes de réalisation de l'invention, la valeur que présente le signal OP à la fin d'une opération, ici la valeur "1", sera considérée comme correspondant à l'émission du signal OP, et la valeur que présente le signal OP pendant l'exécution d'une opération, ici la valeur "0", sera considérée comme correspondant à l'absence de ce signal.

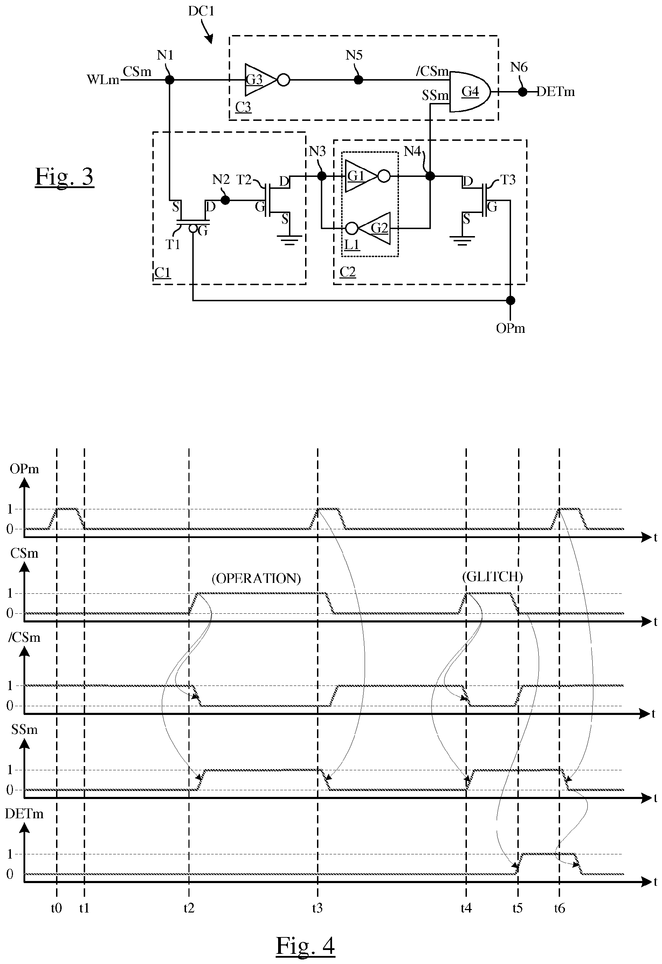

La figure 3 montre un premier mode de réalisation d'un circuit de détection d'impulsion transitoire DC1 selon l'invention. Le circuit DC1 est relié à une ligne de mots WLm du plan mémoire MA1, m étant un index de ligne de mots allant ici de 0 à M-1. Bien qu'une seule ligne de mots soit montrée sur la figure, un circuit de détection DC1 peut être prévu pour chaque ligne de mots (WL₀ à WL_{M-1}) du plan mémoire, ou pour un sous-ensemble de lignes de mots, par exemple des lignes de mots correspondant à une zone mémoire sécurisée.

Le circuit de détection DC1 comprend un nœud d'entrée N1, un nœud de sortie N6, un circuit de détection d'état C1, un circuit de mémorisation d'état C2, et un circuit de détection de changement d'état C3. Le nœud N1 est relié à la ligne de mots WLm et le nœud de sortie N6 fournit un signal de détection d'impulsion transitoire DET de rang m, noté "DETm". Pour simplifier la description qui suit, on désigne par "signal d'état de ligne de mots" ou "signal d'état" un signal en tension CSm présent sur la ligne de mots WLm et considéré dans sa valeur logique, c'est-à-dire comme valant 1 ou 0 s'il est supérieur ou inférieur à un seuil de tension marquant la limite entre le 0 et le 1.

Le circuit de détection d'état C1 comprend un transistor PMOS T1 et un transistor NMOS T2. Le transistor T1 a une borne de conduction (S) reliée au nœud N1, une autre borne de conduction (D) reliée à un nœud N2, et reçoit sur sa borne de commande (G) un signal de fin d'opération OP de rang m, noté OPm. Le transistor T2 a une borne de conduction (S) reliée à la masse, une autre borne de conduction (D) reliée à un nœud N3 (nœud d'entrée de verrou), et une borne de commande (G) reliée au nœud N2.

Le circuit de mémorisation d'état C2 comprend un verrou L1 pour mémoriser l'état détecté au moyen du circuit C1, et un transistor NMOS T3 pour réinitialiser le verrou L1. Le verrou L1 comprend le nœud d'entrée N3, un nœud de sortie N4, une première porte inverseuse G1, et une seconde porte inverseuse G2 montée tête-bêche, la porte G1 ayant son entrée reliée au nœud N3 et sa sortie reliée au nœud N4, et la porte G2 son entrée reliée au nœud N4 et sa sortie reliée au nœud N3. La porte G1 fournit au nœud N4 un signal d'état mémorisé SSm. Le transistor T3 a une borne de conduction (S) reliée à la masse, une autre borne de conduction (D) reliée au nœud N4, et une borne de commande (G) recevant le signal de fin d'opération OPm.

Le circuit de détection de changement d'état C3 comprend une porte inverseuse G3 et une porte logique ET à deux entrées G4. La porte G3 est reliée en entrée au nœud N1, pour recevoir le signal d'état CSm de la ligne de mots WLm, et en sortie à un nœud N5, pour fournir un signal d'état inversé /CSm. La porte G4 a une entrée reliée au nœud N5 et une entrée reliée au nœud N4 du circuit C2, et sa sortie est reliée au nœud N6.

La figure 4 est un chronogramme illustrant le fonctionnement du circuit de détection DC1 de la figure 3, et montre les valeurs logiques du signal de fin d'opération OPm, du signal d'état CSm (c'est-à-dire, l'état de la ligne de mots WLm à l'instant considéré), du signal d'état inversé /CSm, du signal d'état mémorisé SSm, et du signal de détection DETm.

A un instant t0, tel que la mise sous tension (initialisation) de la mémoire MEM ou à la fin d'une opération précédente réalisée sur la ligne de mots WLm ou sur une autre ligne de mots, le signal de fin d'opération OPm est émis (OPm=1). Le transistor T1 est dans l'état non conducteur ou "bloqué", et le transistor T3 est dans l'état conducteur, reliant ainsi le nœud N4 à la masse. Le verrou L1 est par conséquent initialisé à 0, de telle sorte que l'état mémorisé SSm est mis à 0. Le signal d'état CSm sur la ligne de mots WLm est à 0 et le signal inversé /CSm est à 1. La porte G4 reçoit les signaux /CSm=1 et SSm=0, de telle sorte que le signal de détection DETm est à 0 en sortie du circuit de détection DC1.

A un instant t1, le signal OPm n'est plus émis (OPm=0) et le signal d'état CSm reste à 0. Le transistor T1 passe dans l'état conducteur tandis que le transistor T3 se bloque. Le transistor T2 applique le signal CSm=0 présent sur le nœud N1 à la borne de commande du transistor T2, de telle sorte que celui-ci est également bloqué. L'état mémorisé SSm du verrou reste à 0. La porte G4 continue à recevoir les signaux /CSm=1 et SSm=0 en entrée, de telle sorte que le signal de détection DETm reste à 0.

A un instant t2, l'application d'une tension sur la ligne de mots fait passer à 1 le signal d'état CSm. Le signal /CSm passe à 0 avec un léger retard. Le transistor T1 est toujours conducteur du fait que le signal de fin d'opération OPm est toujours égal à 0, et applique la valeur en tension du signal d'état CSm à la borne de commande du transistor T2, qui passe dans l'état conducteur. Le nœud N3 est relié à la masse, tandis que le transistor T3 reste bloqué par le signal OPm égal à 0. Le signal mémorisé SSm sur le nœud de sortie N4 passe à 1 avec un léger retard. La porte G4 reçoit ainsi les signaux /CSm=0 et SSm=1 en entrée, de telle sorte que le signal de détection DETm reste à 0.

A un instant t3, le signal de fin d'opération OPm est émis (OPm=1). Le transistor T1 est de nouveau bloqué, et le transistor T3 est mis dans l'état conducteur, reliant le nœud N4 à la masse de telle sorte que le signal d'état mémorisé SSm est remis à 0. Le signal d'état CSm est ensuite également remis à 0 par le circuit de commande CCT, ce qui termine l'opération (lecture, programmation, effacement) sur la ligne de mots WLm, tout en maintenant le signal OPm à 1. La porte G4 reçoit les signaux /CSm=1 et SSm=0 en entrée, de telle sorte que le signal de détection DETm reste à 0. Le signal OPm est ensuite remis à 0, mettant le transistor T1 dans l'état conducteur et bloquant le transistor T3.

A un instant t4, pendant que le signal de fin d'opération OPm est à 0, une tension non autorisée assimilée au "1" logique est appliquée sur la ligne de mot et le signal d'état CSm de la ligne de mots repasse donc de nouveau à 1. Le signal /CSm passe à 0 avec un léger retard. Le signal de fin d'opération OPm étant à 0, le transistor T1 est dans l'état conducteur et applique la tension non autorisée à la borne de commande du transistor T2, ce qui le met dans l'état conducteur. Le nœud N3 est relié à la masse, et le signal SSm sur le nœud N4 passe à 1 avec un léger retard. La porte G4 reçoit ainsi les signaux /CSm=0 et SSm=1 en entrée, de telle sorte que le signal de détection DETm reste à 0.

A un instant t5, le signal d'état CSm repasse à 0, ce qui correspond à la disparition du signal non autorisé. Le signal /CSm passe à 1, mais comme le signal de fin d'opération OPm est toujours à 0 et n'a pas encore été remis à 1 par le circuit de commande, le nœud N4 n'a pas été remis à 0, de telle sorte que l'état mémorisé de la ligne de mots est inchangé et que l'état mémorisé SSm reste à 1. La porte G4 reçoit les signaux /CSm=1 et SSm=1 et le signal de détection DETm passe à 1, notifiant qu'une impulsion transitoire non autorisée a été détectée sur la ligne de mots.

A un instant t6, le signal de fin d'opération OPm est remis à 1. Le transistor T3 est de nouveau dans l'état conducteur, reliant le nœud N4 à la masse de telle sorte que le signal d'état mémorisé SSm est remis à 0. La porte G4 reçoit ainsi /CSm=1 et SSm=0 en entrée, le signal de détection DETm repasse à 0. Le signal OPm est ensuite remis à 0, ce qui met le transistor T1 dans l'état conducteur et bloque le transistor T3.

L'homme de l'art notera en observant le chronogramme de la figure 4 que le passage de 1 à 0 du signal d'état CSm intervient après l'instant t3 où le signal OPm a été mis à 1, et avant que celui-ci ne soit remis à 0. Ainsi, le passage de 1 à 0 du signal Csm n'est pas détecté comme une impulsion transitoire puisque la valeur 1 du signal OPm a pour effet de réinitialiser le verrou C2 et de le maintenir dans l'état de réinitialisation (transistor T3 passant, SSm=0). Par contre, le passage à 0 du signal CSm à l'instant t5 est détecté comme une impulsion transitoire non autorisée et provoque le passage à 1 du signal DETm car ce front descendant apparaît pendant que le signal OPm est encore à 0 et avant qu'il ne soit remis à 1. Une impulsion transitoire non autorisée ou "glitch" se distingue donc d'un signal d'état régulier CSm appliqué à la ligne de mot en raison de son caractère asynchrone relativement au signal de fin d'opération OPm.

Dans certains modes de réalisation, la durée d'une opération sur des cellules mémoire est de l'ordre de la milliseconde à quelques millisecondes, tandis que le laps de temps entre deux opérations, pendant lequel le signal OPm est mis à 1, est très court et de l'ordre de quelques dizaines de nanosecondes.

Dans des modes de réalisation, la durée pendant laquelle le signal OPm est émis peut être très courte et plus courte que le temps minimal entre deux opérations. Dans un mode de réalisation, le temps pendant lequel le signal OPm est émis est inférieur à 20 nanosecondes, par exemple 1 ns, 5 ns, 10 ns, 15 ns, et est de préférence choisi égal au temps minimal pour remettre le verrou C2 à zéro. Dans ces conditions, il devient quasiment impossible à un attaquant de synchroniser le front descendant d'un signal injecté dans la mémoire avec les instants où le signal OPm est émis.

L'homme de l'art observera également que la valeur logique "1" du signal non autorisé apparaissant sur la figure 4 à partir de l'instant t4, appelée signal d'état CSm, peut correspondre à une amplitude de tension sur la ligne de mot qui ne correspondant pas exactement à la tension générée par la mémoire pour produire un "1" logique. De même, la valeur logique "0" peut correspondre à une amplitude de tension non nulle sur la ligne de mot. La porte inverseuse G3 présente en effet et de façon en soi classique une tension de seuil au-delà de laquelle sa sortie bascule à 0 et en dessous de laquelle sa sortie bascule à 1. Cette tension de seuil est classiquement la tension de seuil des transistors qui la constituent (non représentés). De même, le transistor T2 force la sortie du verrou C2 (signal SSm) à 1 lorsqu'il reçoit un signal en tension supérieur à sa tension de seuil. Le transistor T2 et la porte G3 se comportent ainsi, en présence d'une signal non autorisé dont la valeur en tension ne correspond pas précisément au "1" logique, comme des circuit de détection qui transforment une tension injectée en une valeur logique "1" si celle-ci est supérieure au seuil précité et en une valeur logique "0" si celle-ci est nulle ou inférieure au seuil précité.

Des modes de réalisation de l'invention peuvent par ailleurs prévoir une détection d'une tension négative non autorisée et transformer une telle tension en un "1" logique si celle-ci est en valeur absolue (indépendamment de son signe) supérieure au seuil considéré. De tels modes de réalisation détectent également un front descendant d'amplitude, l'amplitude étant considérée comme une valeur absolue indépendamment du signe de la tension. Il découle de ce qui précède qu'un front descendant à détecter est, de façon générale, une variation du signal détecté entre une valeur en tension correspondant à l'exécution d'une opération et une valeur en tension de non-exécution de l'opération.

Enfin, on a indiqué dans ce qui précède que le signal de fin d'opération est mis à 0 pendant l'exécution d'une opération et est mis à 1 entre deux opérations, pour permettre de remettre à 0 le signal Csm appliqué volontairement sur la ligne de mot sans que cela ne soit détecté comme un signal d'impulsion transitoire non autorisé. Un circuit de détection selon l'invention est toutefois susceptible d'autres applications. Par exemple, le signal OPm, après avoir été émis et avoir réinitialisé le circuit de détection, peut ne plus être émis et donc rester à 0 pendant une période de "repos" où aucune opération n'est effectuée sur des cellules mémoire. L'apparition sur la ligne de mot d'un signal en tension supérieur au seuil de commutation de la porte G3 et du transistor T2, ayant pour effet de faire basculer à 0 le signal /CSm et à 1 le signal SSm, puis la disparition de ce signal, ayant pour effet de faire basculer à 1 le signal /CSm tandis que le signal SSm reste à 1, sera donc détectée à juste titre comme un signal transitoire non autorisé. Le circuit de détection DC1 permet donc également de surveiller la mémoire pendant des périodes de repos.

Dans certains modes de réalisation de l'invention, il peut par ailleurs être souhaitable de verrouiller le signal de détection d'impulsion transitoire DETm de sorte que la détection d'une impulsion transitoire reste activée même après la réinitialisation de l'état mémorisé SSm.

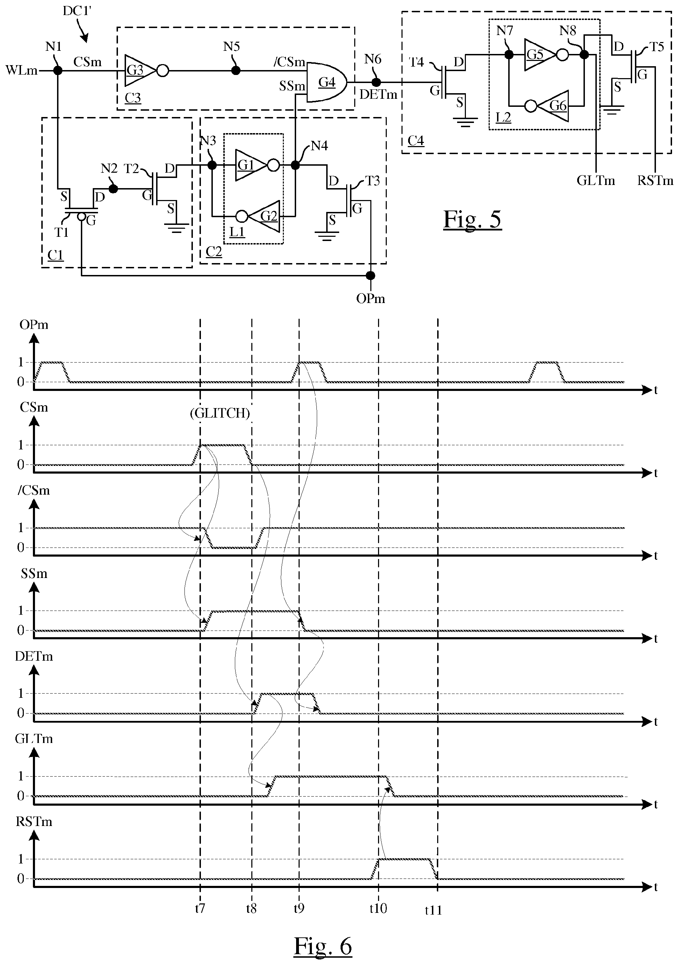

La figure 5 montre un circuit de détection DC1' comprenant en sus des circuits C1, C2, C3 déjà décrits, un circuit de mémorisation de détection d'impulsion transitoire C4 fournissant un signal de détection d'impulsion transitoire mémorisé GLTm. Le circuit C4 reçoit en entrée le signal de détection d'impulsion transitoire DETm et le mémorise jusqu'à ce qu'il soit réinitialisé par un signal de réinitialisation RSTm. Le signal de réinitialisation RSTm est fourni par exemple par le processeur hôte HC (Cf. Fig. 2) lors de la mise sous tension et après chaque détection d'impulsion transitoire, afin de remettre à 0 le signal de détection d'impulsion transitoire mémorisé.

Le circuit de mémorisation C4 comprend un verrou L2 et deux transistors NMOS T4, T5. Le verrou L2 comprend un nœud d'entrée N7, un nœud de sortie N8 fournissant le signal GLTm, une première porte inverseuse G5, et une seconde porte inverseuse G6. Les portes G5, G6 sont montées tête-bêche, la porte G5 ayant une entrée reliée au nœud N7 et une sortie reliée au nœud N8, la porte G6 ayant une entrée reliée au nœud N8 et une sortie reliée au nœud N7. Le transistor T4 a une borne de conduction (S) reliée à la masse, une autre borne de conduction (D) reliée au nœud N7, et sa borne de commande (G) est reliée au nœud N6, en sortie de la porte G4. Le transistor T5 a une borne de conduction (S) reliée à la masse, une autre borne de conduction (D) reliée au nœud N8, et une borne de commande (G) recevant le signal de réinitialisation RSTm.

La figure 6 est un chronogramme illustrant le fonctionnement du circuit de détection DC1' et montrant les valeurs logiques du signal de fin d'opération OPm, du signal d'état CSm, du signal d'état inversé /CSm, du signal d'état mémorisé SSm, du signal de détection DETm, du signal de détection d'impulsion transitoire mémorisé GLTm, et du signal de réinitialisation RSTm. La figure 6 illustre uniquement le cas où une impulsion transitoire non autorisée est détectée. Le fonctionnement du circuit dans le cas de l'exécution d'une opération (lecture, programmation, effacement) est identique à celui illustré sur la figure 4 avec en plus le fait que, aucune impulsion transitoire n'étant dans ce cas détectée, le signal de réinitialisation RSTm et le signal de détection d'impulsion transitoire mémorisé GLTm restent à 0, et qu'ainsi, il n'est pas nécessaire de réinitialiser le circuit C4.

A un instant t7, le signal d'état CSm passe à 1. Le signal /CSm passe à 0 avec un léger retard. Le signal de fin d'opération OPm est absent (OPm=0), de sorte que le transistor T1 est dans l'état conducteur et que le transistor T3 est bloqué. Le transistor T1 applique la valeur logique 1 à la borne de commande du transistor T2, le mettant dans l'état conducteur. Le nœud N3 est relié à la masse, et le signal SSm sur le nœud de sortie N4 passe à 1 avec un léger retard. La porte G4 reçoit ainsi les signaux /CSm=0 et SSm=1 en entrée, de telle sorte que le signal de détection DETm reste à 0.

A un instant t8, le signal d'état CSm repasse à 0. Le signal /CSm passe à 1, mais l'état mémorisé de la ligne de mots reste inchangé, de telle sorte que SSm reste à 1. La porte G4 reçoit les signaux /CSm=1 et SSm=1 en entrée. Le signal de détection DETm passe à 1, notifiant qu'une impulsion transitoire a été détectée sur la ligne de mots. La valeur logique 1 est appliquée à la borne de commande du transistor T4, le mettant dans l'état conducteur. Le nœud N7 est relié à la masse, et la sortie de la porte inverseuse G5 passe à 1 avec un léger retard. Le signal de détection d'impulsion transitoire mémorisé GLTm présent sur le nœud N8 du verrou L2 est mis à 1.

A un instant t9, le signal de fin d'opération OPm est émis (OPm=1). Le transistor T1 est de nouveau bloqué, et le transistor T3 est de nouveau dans l'état conducteur, reliant le nœud N4 à la masse de telle sorte que le signal d'état mémorisé SSm est remis à 0. La porte G4 reçoit ainsi /CSm=1 et SSm=0 en entrée, de telle sorte que le signal de détection DETm repasse à 0 et est appliqué à la borne de commande du transistor T4, le mettant dans l'état bloqué. Toutefois, le signal de détection d'impulsion transitoire mémorisé GLTm reste à 1. Peu après cela, le signal de fin d'opération OPm passe à 0, mettant le transistor T1 dans l'état conducteur et bloquant le transistor T3.

A un instant t10, le signal de réinitialisation RSTm est mis à 1. Le transistor T5 est mis dans l'état conducteur, reliant le nœud N8 à la masse. Le signal de détection d'impulsion transitoire mémorisé GLTm repasse à 0, tandis que les autres signaux ne sont pas affectés. Peu après cela, le signal de réinitialisation RSTm est remis à 0, mettant le transistor T5 dans l'état bloqué.

Dans certains modes de réalisation de l'invention, il peut être souhaitable de fournir un signal de fin d'opération global OP pour une pluralité de circuits de détection. En outre, il peut être souhaitable de fournir en sortie un signal de détection global DET et/ou un signal de détection global GLT pour la totalité du plan mémoire, plutôt que d'en fournir un par ligne de mots (DETm, GLTm). Ces deux aspects seront mis en œuvre conjointement dans les exemples de réalisation qui suivent, mais pourraient aussi être mis en œuvre indépendamment l'un de l'autre.

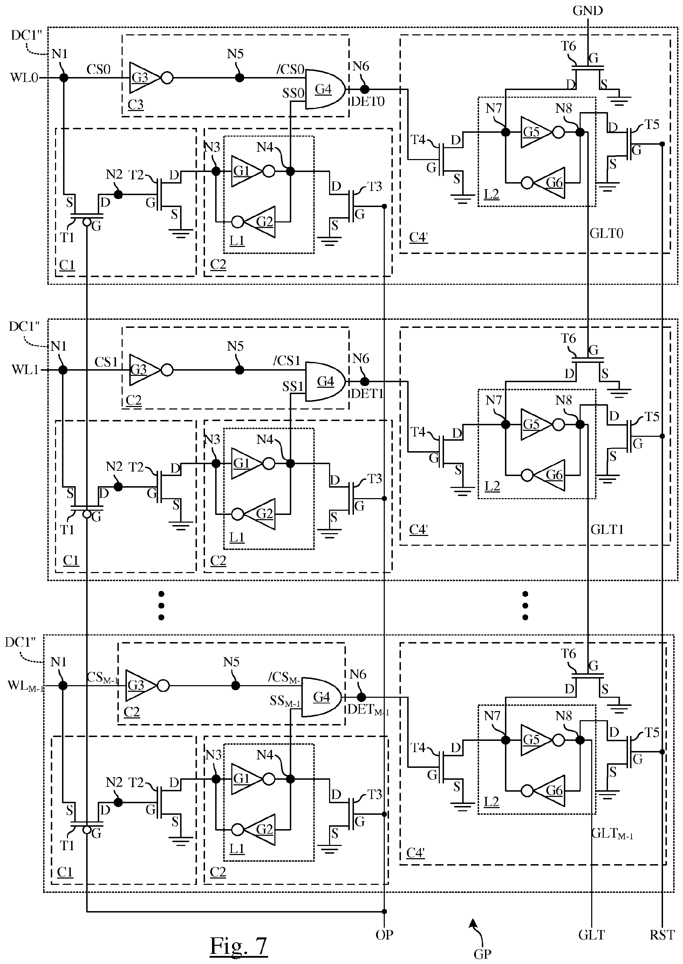

La figure 7 montre une pluralité de lignes de mots WL0, WL1... WL_{M-1}, chacune étant reliée à un circuit de détection DC1", l'ensemble des circuits de détection DC1" formant le groupe GP de circuits de détection. Le signal de fin d'opération OP et le signal de réinitialisation RST sont communs à tous les circuits de détection. Les circuits de détection DC1" sont reliés en cascade de manière que chaque circuit de détection à l'exception du premier reçoive le signal de détection d'impulsion transitoire fourni par un circuit de détection précédent, et bascule dans un état de détection d'une impulsion transitoire lorsque le circuit de détection précédent est lui-même dans l'état de détection d'une impulsion transitoire, le dernier circuit DC1" fournissant un signal de détection d'impulsion transitoire global GLT.

A cet effet, les circuits de détection DC1" comprennent chacun un circuit de mémorisation de détection d'impulsion transitoire C4' qui diffère du circuit de mémorisation de détection d'impulsion transitoire C4 précédemment décrit en ce qu'il comprend en outre un transistor NMOS T6 ayant une borne de conduction (S) reliée à la masse, une autre borne de conduction (D) reliée au nœud N7, et dont la borne de commande (G) reçoit le signal de détection d'impulsion transitoire mémorisé fourni par le circuit de détection DC1" relié à la ligne de mots WLₘ₋₁ précédente. De manière similaire, chaque nœud de sortie N8 est relié à la borne de commande du transistor T6 du circuit de détection DC1" relié à la ligne de mots WLₘ₊₁ suivante.

Lorsqu'un signal de détection d'impulsion transitoire mémorisé GLTm passe à 1, le transistor T6 du circuit de détection suivant est mis dans l'état conducteur, reliant le nœud d'entrée N7 du verrou L2 à la masse et mettant le nœud N8 à 1, de telle sorte que le signal de détection d'impulsion transitoire mémorisé se propage à la totalité des autres circuits de détection, qu'une impulsion transitoire ait été détectée ou non sur les autres lignes de mot.

Il sera noté que le transistor T6 circuit de détection DC1" relié à la première ligne de mots WL0 du plan mémoire a sa borne de commande reliée à la masse GND de sorte que ce transistor reste inactif. En variante, la première ligne de mots WL0 peut être reliée à un circuit de détection DC1' tel que décrit en relation avec la figure 5, ne comprenant pas ce transistor.

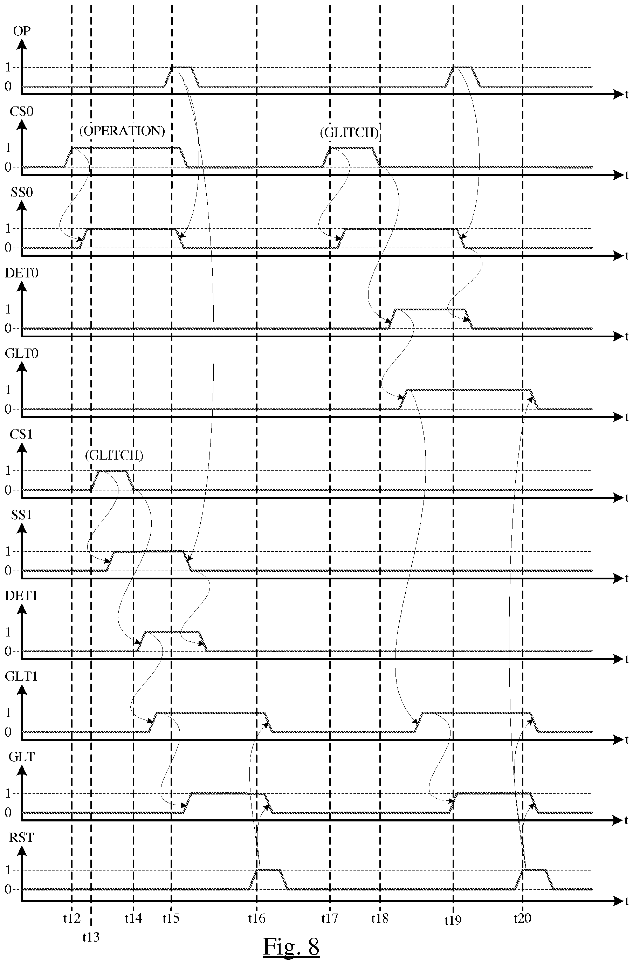

La figure 8 est un chronogramme illustrant le fonctionnement d'un circuit de détection DC1" de la figure 7. La figure 8 montre les valeurs logiques du signal de fin d'opération OP, du signal de détection d'impulsion transitoire global GLT, du signal de réinitialisation RST, des signaux CS0, SS0, DET0, GLT0, en relation avec la ligne de mots WL0, et des signaux CS1, SS1, DET1, GLT1 en relation avec la ligne de mots WL1.

A un instant t12, le signal d'état CS0 passe à 1 tandis que le signal de fin d'opération OP est absent (OP=0). Le signal SS0 passe à 1 avec un léger retard, et le signal de détection DETO reste à 0. A un instant t13, le signal d'état CS1 passe également à 1 tandis que le signal de fin d'opération OP reste à 0. Le signal SS1 passe à 1 avec un léger retard, et le signal de détection DET1 reste à 0. A un instant t14, le signal d'état CS1 repasse à 0. L'état mémorisé SS1 de la ligne de mots WL1 reste inchangé, de telle sorte que le signal de détection DET1 passe à 1. Le signal de détection d'impulsion transitoire mémorisé GLT1 est mis à 1 et se propage à travers les circuits de détection reliés aux lignes de mots suivantes WL2 à WL_{M-1}. Le signal de détection d'impulsion transitoire global GLT passe à 1 en sortie du dernier circuit de détection. A un instant t15, le signal de fin d'opération OP est émis (OP=1). Les signaux d'état mémorisés SS0, SS1 sont remis à 0. Le signal d'état CS0 et le signal de détection DET1 repassent à 0. Les signaux de détection d'impulsion transitoire mémorisés GLT1... et le signal de détection d'impulsion transitoire global GLT restent à 1. Le signal d'état CS0 repasse à 0. A un instant t16, le signal de réinitialisation RST est mis à 1, reliant les nœuds de sortie N8 à la masse. Les signaux de détection d'impulsion transitoire GLT1... GLT repassent à 0, tandis que les autres signaux ne sont pas affectés. Le signal de réinitialisation RST est ensuite remis à 0, mettant les transistors T5 dans l'état bloqué. Par conséquent, une impulsion transitoire apparaissant sur une ou plusieurs lignes de mots est détectable tandis qu'au même instant une autre ligne de mots est utilisée pour une opération sur des cellules mémoire.

A un instant t17, le signal d'état CS0 passe à 1 tandis que le signal de fin d'opération OP est à 0. Le signal SS0 passe à 1 avec un léger retard, et le signal de détection DETO reste à 0. A un instant t18, le signal d'état CS0 repasse à 0. L'état mémorisé SS0 de la ligne de mots WL0 reste inchangé, et le signal de détection DETO passe à 1. Le signal de détection d'impulsion transitoire mémorisé GLT0 est mis à 1 et se propage à travers les circuits de détection reliés aux lignes de mots suivantes (WL1 à WL_{M-1}). De cette manière, tous les signaux de détection d'impulsion transitoire mémorisés GLT1... sont mis à 1 et le signal de détection d'impulsion transitoire global GLT passe à 1 en sortie du dernier circuit de détection. A un instant t19, le signal de fin d'opération OP est émis (OP=1). Le signal d'état mémorisé SS0 est remis à 0, et le signal de détection DETO repasse à 0. Les signaux de détection d'impulsion transitoire GLT0, GLT1 ... GLT restent à 1. A un instant t20, le signal de réinitialisation RST est mis à 1, reliant les nœuds de sortie N8 à la masse. Les signaux de détection d'impulsion transitoire GLT0, GLT1... GLT repassent à 0, tandis que les autres signaux ne sont pas affectés. Le signal de réinitialisation RST est ensuite remis à 0, mettant les transistors T5 dans l'état bloqué.

Ce mode de réalisation montre qu'une impulsion transitoire peut être détectée sur une ou plusieurs lignes de mots tandis que les autres lignes de mots sont utilisées pour une opération sur des cellules mémoire, tout en utilisant un signal de fin d'opération global OP.

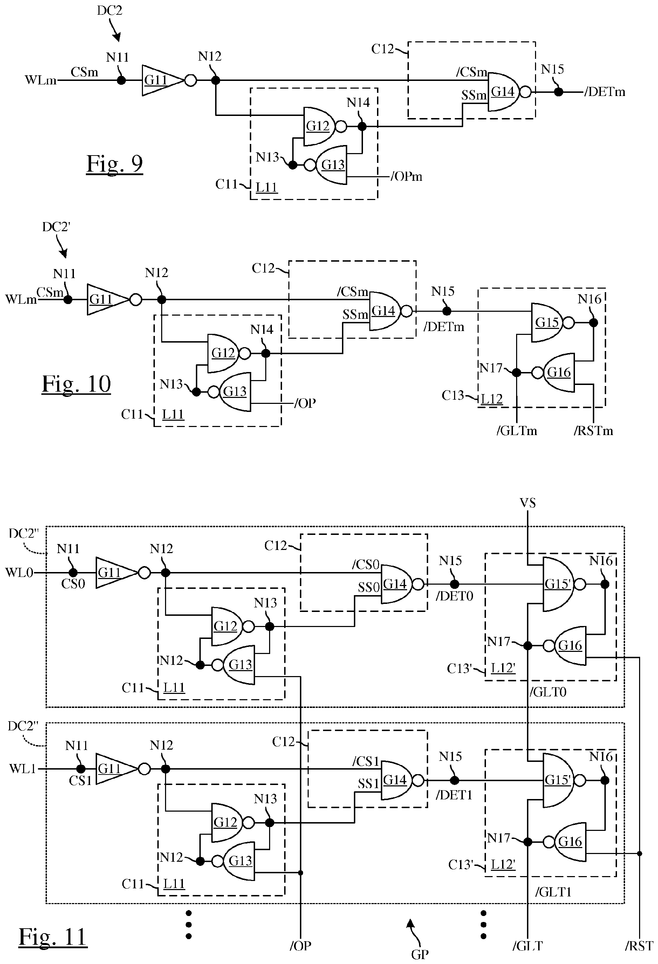

La figure 9 montre un circuit de détection d'impulsion transitoire DC2 selon un autre mode de réalisation de l'invention. Le circuit de détection DC2 comprend un nœud d'entrée N11 relié à une ligne de mots WLm, un nœud de sortie N15 fournissant un signal de détection d'impulsion transitoire DETm, une porte inverseuse G11, un circuit de réinitialisation, de détection et de mémorisation d'état C11, et un circuit de détection de changement d'état C12.

La porte inverseuse G11 est reliée sur son entrée au nœud N11 et sur sa sortie à un nœud N12. Le circuit de mémorisation C11 comprend un verrou L11 comprenant un nœud d'entrée de verrou N12, un nœud intermédiaire N13, un nœud de sortie N14, une première porte NON-ET à deux entrées G12, et une seconde porte NON-ET à deux entrées G13. Les portes G12, G13 sont montées tête-bêche, la porte G12 ayant une entrée reliée au nœud N12, une autre entrée reliée au nœud N13, et une sortie reliée au nœud N14, tandis que la porte G13 a une entrée reliée au nœud N14, une autre entrée recevant le signal de fin d'opération inversé /OPm, et une sortie reliée au nœud N13. Le circuit de détection de changement C12 comprend une porte NON-ET à deux entrées G14 reliée sur une entrée au nœud N12, sur une entrée au nœud N14, et en sortie au nœud N15.

Le fonctionnement du circuit de détection DC2 est similaire à celui illustré par le chronogramme de la figure 4, à l'exception du fait que le circuit est commandé par le signal de fin d'opération inversé /OPm qui est à 1 pendant une phase de détection (état "non émis") et à 0 (état "émis") pour réinitialiser l'état mémorisé SSm du verrou L11. En outre, le signal de détection /DETm passe à 0 lorsqu'une impulsion transitoire est détectée.

La figure 10 montre un circuit de détection DC2' selon un autre mode de réalisation de l'invention. Le circuit de détection DC2' est similaire au circuit de détection DC2 décrit en relation avec la figure 9, les mêmes références désignant les mêmes éléments, et comprend en sus un circuit de mémorisation de détection d'impulsion transitoire C13. Le circuit de mémorisation C13 reçoit en entrée le signal de détection d'impulsion transitoire /DETm et le mémorise jusqu'à être réinitialisé par un signal de réinitialisation inversé /RSTm. Le signal /RSTm est fourni par le processeur hôte et est par exemple appliqué lors de la mise sous tension et après chaque détection d'impulsion transitoire, afin de réinitialiser le signal de détection d'impulsion transitoire mémorisé.

Le circuit de mémorisation C13 comprend un verrou L12 comprenant une première porte NON-ET à deux entrées G15, une seconde porte NON-ET à deux entrées G16, un nœud intermédiaire N16, et un nœud de mémorisation N17. Les portes G15, G16 sont montées tête-bêche, la porte G15 ayant une entrée reliée au nœud N15, une autre entrée reliée au nœud N17, et une sortie reliée au nœud N16, tandis que la porte G16 a une entrée reliée au nœud N16, une autre entrée recevant le signal de réinitialisation inversé /RSTm, et une sortie reliée au nœud N17.

Le fonctionnement du circuit de détection DC2' est similaire à celui illustré par le chronogramme de la figure 6, à l'exception du fait que le signal de fin d'opération /OPm et le signal de réinitialisation /RSTm sont normalement à 1 et passent à 0 pour réinitialiser l'état mémorisé SSm et le signal de détection d'impulsion transitoire mémorisé /GLTm. En outre, le signal de détection /DETm et le signal de détection d'impulsion transitoire mémorisé /GLTm sont normalement à 1 et passent à 0 lorsqu'une impulsion transitoire est détectée.

La figure 11 montre une pluralité de lignes de mots WL0, WL1..., chacune étant reliée à un circuit de détection DC2" selon un autre mode de réalisation de l'invention, les circuits de détection DC2" formant le groupe GP de circuits de détection recevant le même signal de fin d'opération /OP et même le signal de réinitialisation /RST.

Les circuits de détection DC2" sont reliés en cascade de manière que chaque circuit de détection à l'exception du premier reçoive le signal de détection d'impulsion transitoire fourni par un circuit de détection précédent, et bascule dans un état de détection d'une impulsion transitoire lorsque le circuit de détection précédent est lui-même dans l'état de détection d'une impulsion transitoire, le dernier circuit DC2" fournissant un signal de détection d'impulsion transitoire global /GLT.

Plus particulièrement, les circuits de détection DC2" comprennent chacun un circuit à verrouillage de détection d'impulsion transitoire C13', qui diffère du circuit à verrouillage C13 précédemment décrit en ce que le verrou L12' comprend une porte NON-ET à trois entrées G15' au lieu de la porte NON-ET à deux entrées G15. La porte G15' a une entrée reliée à son propre nœud d'entrée de verrou N15, une entrée reliée à son propre nœud de sortie de verrou N17, et une entrée reliée au nœud de sortie N17 du circuit de détection relié à la ligne de mots précédente WLₘ₋₁. De manière similaire, chaque nœud de sortie N17 est relié à une entrée de la porte G15' du circuit de détection DC2" relié à la ligne de mots suivante WLₘ₊₁. Par conséquent, si un signal de détection d'impulsion transitoire mémorisé GLTm passe à 0, la porte NON-ET N15' de chaque circuit de détection suivant propage l'impulsion transitoire détectée à travers la totalité du groupe restant de circuits de détection de ligne de mots, qu'une impulsion transitoire soit ou non détectée sur ces lignes de mots. Le circuit de détection DC2" relié à la première ligne de mots WL0 du plan mémoire a une des entrées de sa porte N15' reliée à une source de tension VS. En variante, la première ligne de mots WL0 peut être reliée à un circuit de détection DC2' tel que décrit en relation avec la figure 10, c'est-à-dire, avec une porte NON-ET à deux entrées N15. Les lignes de mots suivantes WL1 à WL_{M-1} sont ensuite reliées chacune au circuit de détection DC2".

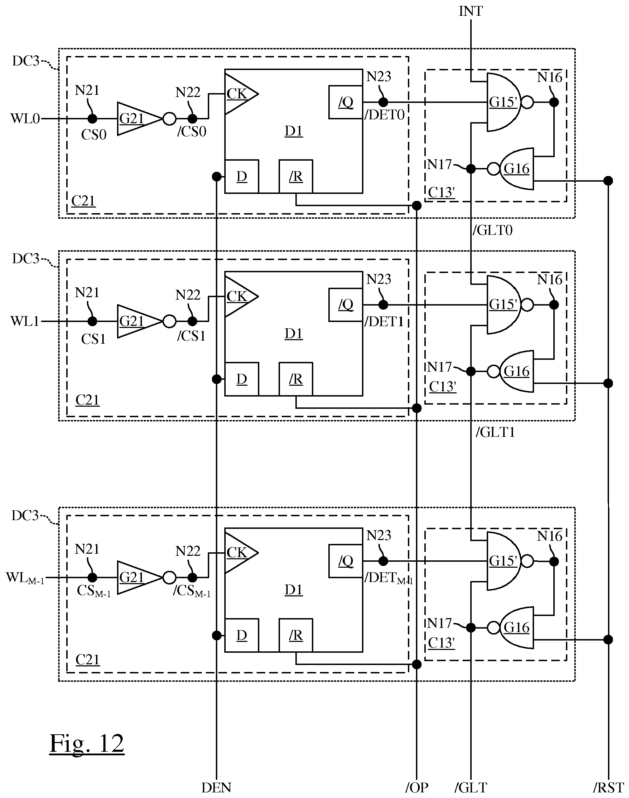

La figure 12 montre une pluralité de lignes de mots WL0, WL1... WL_{M-1}, chacune étant reliée à un circuit de détection DC3 selon encore un autre mode de réalisation de l'invention. Plutôt que de mémoriser l'état haut du signal d'état de la ligne de mots, et de le comparer au signal d'état courant de la ligne de mots, le circuit de détection DC3 détecte directement un front descendant du signal d'état présent sur la ligne de mots pendant qu'une opération est en cours. La présence de ce front descendant implique la présence préalable d'un signal en tension égal ou supérieur au seuil correspondant au "1" logique suivi d'une variation de ce signal en tension au-dessous du seuil du "1" logique, correspondant au "0" logique.

Chaque circuit de détection DC3 comprend un circuit C21 de détection et de mémorisation de front descendant présentant un nœud d'entrée N21 relié à une ligne de mots WLm et un nœud de sortie N23 fournissant un signal de détection d'impulsion transitoire /DETm (/DET0, /DET1 ... /DET_{M-1}). Un circuit de mémorisation de détection d'impulsion transitoire C13', tel que celui décrit en relation avec la figure 11, peut être prévu en sortie du circuit C21 pour verrouiller le signal de détection d'impulsion transitoire.

Le circuit C21 comprend une porte inverseuse G21 et une bascule D1. La bascule D1 comprend une entrée d'horloge CK, une entrée de données D, une entrée de réinitialisation /R, et une sortie inversée /Q. L'entrée CK est reliée au nœud d'entrée N21 au moyen de la porte inverseuse G21, qui fournit le signal de ligne de mots inversé /CSm. L'entrée D reçoit un signal d'activation de détection DEN, qui peut varier entre 0 et 1, ou être en permanence sur 1, par exemple la tension d'alimentation du circuit. L'entrée de réinitialisation /R reçoit le signal de fin d'opération inversé /OP, et la sortie /Q fournit le signal de détection inversé /DET. Lorsque le signal /OP est mis à 0, la bascule D1 est initialisée et le signal de détection /DET sur la sortie /Q est mis à 1. Lorsque le signal /OP est mis à 1, un front descendant du signal sur la ligne de mots peut être détecté. Lorsqu'un tel front descendant apparaît, la sortie /Q de la bascule D1 passe à 0.

Il apparaîtra clairement à l'homme de l'art que la détection sur une ligne de mots d'un signal ayant une valeur logique élevée correspondant au "1" logique, peut être réalisée différemment. Par exemple, dans une variante de réalisation basée sur la détection d'un front descendant, au lieu de réinitialiser la bascule D1 avec le signal de fin d'opération OP, un signal de détection de front descendant est mis à 1 et est simplement comparé, par exemple à l'aide d'une porte logique ET, à la valeur du signal de fin d'opération OP. De manière similaire, plutôt que de détecter un front descendant, un front montant peut être détecté, selon les valeurs logiques des signaux.

Dans un mode de réalisation, au lieu d'appliquer le signal de fin d'opération OP aux bornes de commande des deux transistors T1, T3 montrés sur les figures 3, 5, 7, le signal peut être divisé en signaux individuels, par exemple un signal d'activation de détection appliqué aux bornes de commande des transistors T1, et un signal de réinitialisation d'état mémorisé appliqué aux bornes de commande des transistors T3. Le signal d'activation de détection peut par conséquent être maintenu à la valeur logique 1 pour bloquer le transistor T1 lorsqu'il n'est pas souhaitable de mettre en œuvre la détection d'impulsion transitoire, et peut passer à 0 pour activer la détection d'impulsion transitoire.

Dans un mode de réalisation, plutôt que de propager un signal de détection d'impulsion transitoire mémorisé, par exemple GLT0, au sein d'une pluralité de circuits de détection d'impulsion transitoire, comme montré sur les figures 7, 11 et 12, les signaux de détection DET0, DET1... DET_{M-1} ou les signaux de détection d'impulsion transitoire mémorisés GLT0, GLT1... GLT_{M-1} peuvent être appliqués en entrée d'une ou de plusieurs portes logiques OU, de telle sorte que si un quelconque signal passe à 1, un signal résultant passe également à 1.

Il va également de soi que les transistors utilisés peuvent être de type P ou de type N, que les signaux OP, CS, /CS, SS, RST, DET, GLT peuvent être inversés, et que différentes portes logiques, configurations de verrou, etc., peuvent être mises en œuvre.

Comme précédemment indiqué, l'homme de l'art comprendra que le signal d'état égal au "0" logique peut correspondre à un potentiel de masse sur la ligne de mots, ou un potentiel inférieur à un seuil, tandis qu'un signal d'état à 1 peut correspondre à une tension supérieure à ce seuil appliquée à la ligne de mots. Ainsi, un seuil de tension peut être fixé, en-dessous duquel il est considéré qu'un signal est au "0" logique.

L'homme de l'art comprendra également que certains signaux écrit dans ce qui précède peuvent être fournis par le processeur hôte HC ou fournis à celui-ci. En particulier, les signaux DET, /DET, GLT, /GLT peuvent être communiqués au processeur hôte afin qu'il puisse prendre les mesures de sécurité appropriées en réponse à la détection d'un signal transitoire non autorisé, telles que la répétition d'une opération, l'effacement de cellules mémoire, le blocage du fonctionnement du dispositif, l'activation d'un drapeau, etc.

Egalement, bien que l'on ait décrit dans ce qui précède des modes de réalisation dans lesquels un front descendant n'est plus détecté lorsque le signal de fin d'opération est à sa valeur de fin d'opération, soit "1" dans les exemples décrits, ce qui a pour conséquence le fait que le signal de détection d'impulsion transitoire n'est pas émis, des modes de réalisation équivalents peuvent prévoir une détection permanente de front descendant, indépendante de la valeur du signal de fin d'opération, et prévoir seulement une inhibition de la fourniture du signal de détection d'impulsion transitoire lorsque le signal de fin d'opération est à 1, une telle inhibition étant équivalente à une absence de détection. Il convient dans ce cas de réinitialiser les moyens de détection d'une autre manière, par exemple au moyen d'un autre signal ou en utilisant le front descendant du signal de fin d'opération comme moyen de réinitialisation, pour initier une nouvelle phase de détection.

Également, bien que l'on ait décrit dans ce qui précède des modes de réalisation de l'invention se rapportant à la détection d'une impulsion transitoire non autorisée sur une ligne de mots, ces modes de réalisation sont également applicables à la détection d'impulsions transitoires sur d'autres lignes de la mémoire, telles que des lignes de contrôle de grille ou des lignes d'effacement (non représentées) du plan mémoire et, de façon générale, toute ligne de contrôle qui ne nécessite pas d'être préchargée avec une tension continue.

## Revendications

1. Mémoire (MEM1) comprenant :
- un circuit de commande (CCT, HC) pour exécuter des opérations de lecture, de programmation ou d'effacement de cellules mémoire, et
- au moins une ligne de mots (WLm) à laquelle sont reliées des cellules mémoire (MC),
**caractérisée en ce que** le circuit de commande est configuré pour émettre un signal logique de fin d'opération (OP, OPm, /OP, /OPm) à la fin de l'exécution d'une opération sur au moins une cellule mémoire,
et **en ce qu'**elle comprend au moins un circuit de détection d'une impulsion transitoire non autorisée pouvant être représentative d'une attaque par injection de faute (DC, DC1, DC1', DC1", DC2, DC2', DC2", DC3) relié à la ligne de mots (WLm) de la mémoire, recevant le signal de fin d'opération et configuré pour fournir un signal de détection d'une impulsion transitoire (DET, DETm, /DETm, GLT, GLTm, /GLTm) lorsqu'un front descendant de l'amplitude d'un signal en tension (Csm) apparaît sur la ligne de mots de la mémoire en l'absence du signal de fin d'opération.

2. Mémoire selon la revendication 1, dans laquelle le circuit de commande est configuré pour :
- pendant l'exécution de l'opération sur la cellule mémoire, appliquer un signal en tension (Csm) sur la ligne de mots (WLm) de la mémoire,
- au terme de l'opération, émettre le signal de fin d'opération (OP, OPm, /OP, /OPm) avant de cesser d'appliquer le signal en tension (Csm) sur la ligne de mots de la mémoire, puis cesser d'émettre le signal de fin d'opération après avoir cessé d'appliquer le signal en tension sur la ligne de mots de la mémoire.

3. Mémoire selon l'une des revendications 1 et 2, dans laquelle le circuit de commande est configuré pour, au terme de l'opération, émettre le signal de fin d'opération pendant moins de 20 nanosecondes.

4. Mémoire selon l'une des revendications 1 à 3, dans laquelle le circuit de détection d'impulsion transitoire (DC, DC1, DC1', DC1", DC2, DC2', DC2") comprend :
- des moyens de détection (C1, T1, T2, G3, G11) configurés pour transformer un signal en tension (Csm) présent sur la ligne de mots de la mémoire (WLm) en un signal logique ayant une première valeur logique lorsque l'amplitude du signal en tension est en dessous d'un seuil et une seconde valeur logique lorsque l'amplitude du signal en tension est au-dessus du seuil,
- des moyens de mémorisation (C2, G1, G2, C11, G12, G13) d'un passage du signal logique de la première à la seconde valeur logique, et
- des moyens (C3, G4, C12, G14) pour fournir le signal de détection d'impulsion transitoire (DET, DETm, /DETm, GLT, GLTm, /GLTm) lorsque le signal logique présente la première valeur logique tandis que les moyens de mémorisation ont mémorisé le passage du signal logique à la seconde valeur logique, sauf si le signal de fin d'opération est présent.

5. Mémoire selon la revendication 4, dans laquelle les moyens de mémorisation (C2, C11) sont configurés (T3) pour être effacés lorsque le signal de fin d'opération est émis.

6. Mémoire selon l'une des revendications 1 à 3, dans laquelle le circuit de détection d'impulsion transitoire (DC3) comprend :
- des moyens de détection (G21) configurés pour transformer un signal en tension (Csm) présent sur la ligne de mots de la mémoire (WLm) en un signal logique ayant une première valeur logique lorsque l'amplitude du signal en tension est en dessous d'un seuil et une seconde valeur logique lorsque l'amplitude du signal en tension est au-dessus du seuil, et
- une bascule logique (D1) configurée pour fournir un signal de détection d'impulsion transitoire (/DETm, /GLTm) lorsque le signal logique passe de la seconde à la première valeur logique.

7. Mémoire selon l'une des revendications 1 à 6, dans laquelle le circuit de détection d'impulsion transitoire comprend un circuit de mémorisation d'impulsion transitoire (C4, C4', C13, C13') fournissant un signal de détection d'impulsion transitoire (GLT, /GLT, GLTm) qui persiste après que le signal de fin d'opération a été émis.

8. Mémoire selon l'une des revendications 1 à 7, comprenant une pluralité de lignes de mots et une pluralité de circuits de détection d'impulsion transitoire (DC1", DC2", DC3) reliés chacun à une ligne de mots de la mémoire et recevant chacun le signal de fin d'opération (OP, OPm, /OP, /OPm), et des moyens pour fournir un signal de détection d'impulsion transitoire collectif (DET, GLT) qui est fonction de signaux de détection d'impulsion transitoire individuels fournis par les circuits de détection.

9. Mémoire selon l'une des revendications 1 à 8, dans laquelle le circuit de commande est configuré pour émettre le signal de fin d'opération (OP, OPm, /OP, /OPm) au terme d'une opération choisie parmi une opération de lecture, d'écriture, ou d'effacement d'une cellule mémoire.

10. Mémoire selon l'une des revendications 1 à 9, dans laquelle le circuit de commande est configuré pour ne pas émettre le signal de fin d'opération (OP, OPm, /OP, /OPm) lorsqu'il n'exécute aucune opération sur des cellules mémoire.

11. Procédé pour surveiller une ligne de mots (WLm) d'une mémoire (MEM1) susceptible de recevoir une impulsion transitoire pouvant être représentative d'une attaque par injection de faute, la mémoire comprenant des cellules mémoire (MC) reliées à la ligne de mots de la mémoire, et un circuit de commande (CCT, HC) pour exécuter des opérations de lecture, de programmation ou d'effacement de cellules mémoire,
procédé **caractérisé en ce qu'**il comprend les étapes consistant à :
- émettre par le circuit de commande (CCT, HC) un signal de fin d'opération (OP, OPm, /OP, /OPm) à la fin de l'exécution d'une opération de lecture, de programmation ou d'effacement d'au moins une cellule mémoire,
- fournir un signal de détection d'impulsion transitoire lorsqu'un front descendant de l'amplitude d'un signal en tension (Csm) apparaît sur la ligne de mots de la mémoire en l'absence du signal de fin d'opération.

12. Procédé selon la revendication 11, comprenant les étapes consistant à :
- pendant l'exécution de l'opération sur la cellule mémoire, appliquer un signal en tension (Csm) sur la ligne de mots (WLm) de la mémoire,
- au terme de l'opération, émettre le signal de fin d'opération (OP, OPm, /OP, /OPm) avant de cesser d'appliquer le signal en tension (Csm) sur la ligne de mots de la mémoire, puis cesser d'émettre le signal de fin d'opération après avoir cessé d'appliquer le signal en tension sur la ligne de mots de la mémoire.

13. Procédé selon l'une des revendications 11 et 12 dans lequel le signal de fin d'opération est émis pendant moins de 20 nanosecondes.

14. Procédé selon l'une des revendications 11 à 13, comprenant l'étape consistant à ne pas émettre le signal de fin d'opération lorsqu'aucune opération n'est exécutée sur des cellules mémoire, pour détecter une impulsion transitoire en dehors de périodes où les cellules mémoire sont utilisées.

## Patentansprüche

1. Speicher (MEM1), umfassend:
- eine Steuerschaltung (CCT, HC) zum Ausführen von Operationen des Lesens, Programmierens oder Löschens von Speicherzellen und
- mindestens eine Wortleitung (WLm), an welche Speicherzellen (MC) angeschlossen sind, **dadurch gekennzeichnet, dass** die Steuerschaltung dafür konfiguriert ist, ein Logiksignal für das Ende der Operation (OP, OPm, /OP, /OPm) am Ende des Ausführens einer Operation an mindestens einer Speicherzelle zu senden, und dass sie mindestens eine Erkennungsschaltung eines transienten, nicht autorisierten Impulses umfasst, die für einen Angriff durch eine Fehlerinjektion (DC, DC1, DC1', DC1", DC2, DC2', DC2", DC3) repräsentativ sein kann, die an die Wortleitung (WLm) des Speichers angeschlossen ist, welche das Signal für das Ende der Operation empfängt und dafür konfiguriert ist, ein Erkennungssignal eines transienten Impulses (DET, DETm, /DETm, GLT, GLTm, /GLTm) bereitzustellen, wenn eine fallende Flanke der Amplitude eines Spannungssignals (Csm) auf der Wortleitung des Speichers erscheint, wenn das Signal für das Ende der Operation fehlt.

2. Speicher nach Anspruch 1, wobei die Steuerschaltung für Folgendes konfiguriert ist:
- Anlegen eines Spannungssignals (Csm) an die Wortleitung (WLm) des Speichers während des Ausführens der Operation an der Speicherzelle,
- Senden des Signals für das Ende der Operation (OP, OPm, /OP, /OPm) am Ende der Operation, bevor das Anlegen des Spannungssignals (Csm) an die Wortleitung des Speichers gestoppt wird, und anschließend Stoppen des Sendens des Signals für das Ende der Operation, nachdem das Anlegen des Spannungssignals an die Wortleitung des Speichers gestoppt wurde.

3. Speicher nach einem der Ansprüche 1 und 2, wobei die Steuerschaltung dafür konfiguriert ist, am Ende der Operation das Signal für das Ende der Operation für weniger als 20 Nanosekunden zu senden.

4. Speicher nach einem der Ansprüche 1 bis 3, wobei Erkennungsschaltung des transienten Impulses (DC, DC1, DC1', DC1", DC2, DC2', DC2") umfasst:
- Erkennungsmittel (C1, T1, T2, G3, G11), die dafür konfiguriert sind, ein auf der Wortleitung des Speichers (WLm) vorhandenes Spannungssignal (Csm) in ein Logiksignal mit einem ersten Logikwert umzuwandeln, wenn die Amplitude des Spannungssignals unter einem Schwellenwert liegt, und in einen zweiten Logikwert umzuwandeln, wenn die Amplitude des Spannungssignals über dem Schwellenwert liegt,
- Speichermittel (C2, G1, G2, C11, G12, G13) eines Durchgangs des Logiksignals vom ersten zum zweiten Logikwert und
- Mittel (C3, G4, C12, G14) zum Bereitstellen des Erkennungssignals des transienten Impulses (DET, DETm, /DETm, GLT, GLTm, /GLTm), wenn das Logiksignal den ersten Logikwert darstellt, während die Speichermittel den Durchgang des Logiksignals zum zweiten Logikwert gespeichert haben, es sei denn, das Signal für das Ende der Operation ist vorhanden.

5. Speicher nach Anspruch 4, wobei die Speichermittel (C2, C11) dafür konfiguriert sind (T3), gelöscht zu werden, wenn das Signal für das Ende der Operation gesendet wird.

6. Speicher nach einem der Ansprüche 1 bis 3, wobei die Erkennungsschaltung eines transienten Impulses (DC3) umfasst:
- Erkennungsmittel (G21), die dafür konfiguriert sind, ein auf der Wortleitung des Speichers (WLm) vorhandenes Spannungssignal (Csm) in ein Logiksignal mit einem ersten Logikwert umzuwandeln, wenn die Amplitude des Spannungssignals unter einem Schwellenwert liegt, und in einen zweiten Logikwert umzuwandeln, wenn die Amplitude des Spannungssignals über dem Schwellenwert liegt, und
- ein logisches Flipflop (D1), das dafür konfiguriert ist, ein Erkennungssignal des transienten Impulses (/DETm, /GLTm) bereitzustellen, wenn sich das Logiksignal vom zweiten zum ersten Logikwert ändert.

7. Speicher nach einem der Ansprüche 1 bis 6, wobei die Erkennungsschaltung des transienten Impulses eine Speicherschaltung des transienten Impulses (C4, C4', C13, C13') umfasst, die ein Erkennungssignal des transienten Impulses (GLT, /GLT, GLTm) bereitstellt, das nach dem Senden des Signals für das Ende der Operation bestehen bleibt.

8. Speicher nach einem der Ansprüche 1 bis 7, umfassend mehrere Wortleitungen und mehrere Erkennungsschaltungen eines transienten Impulses (DC1", DC2", DC3), die jeweils mit einer Wortleitung des Speichers verbunden sind und das Signal für das Ende der Operation (OP, OPm, /OP, /OPm) empfangen, und Mittel zum Bereitstellen eines kollektiven Erkennungssignals eines transienten Impulses (DET, GLT), das abhängig von einzelnen Erkennungssignalen des transienten Impulses ist, die von den Erkennungsschaltungen bereitgestellt werden.

9. Speicher nach einem der Ansprüche 1 bis 8, wobei die Steuerschaltung dafür konfiguriert ist, das Signal für das Ende der Operation (OP, OPm, /OP, /OPm) am Ende einer Operation zu senden, die aus einer Operation des Lesens, Schreibens oder Löschens einer Speicherzelle ausgewählt ist.

10. Speicher nach einem der Ansprüche 1 bis 9, wobei die Steuerschaltung dafür konfiguriert ist, das Signal für das Ende der Operation (OP, OPm, /OP, /OPm) nicht zu senden, wenn sie keine Operation an Speicherzellen durchführt.

11. Verfahren zur Überwachung einer Wortleitung (WLn) eines Speichers (MEM1), der einen transienten Impuls empfangen kann, der für einen Angriff durch eine Fehlerinjektion repräsentativ sein kann, wobei der Speicher Speicherzellen (MC), die an die Wortleitung des Speichers angeschlossen sind, und eine Steuerschaltung (CCT, HC) zum Ausführen von Operationen des Lesens, Programmierens oder Löschens von Speicherzellen umfasst, wobei das Verfahren **dadurch gekennzeichnet ist, dass** es die folgenden Schritte umfasst:
- Senden eines Signals für das Ende der Operation (OP, OPm, /OP, /OPm) durch die Steuerschaltung (CCT, HC) am Ende des Ausführens einer Operation des Lesens, Programmierens oder Löschens mindestens einer Speicherzelle,
- Bereitstellen eines Erkennungssignals eines transienten Impulses, wenn eine fallende Flanke der Amplitude eines Spannungssignals (Csm) auf der Wortleitung des Speichers erscheint, wenn das Signal für das Ende der Operation fehlt.

12. Verfahren nach Anspruch 11, das die folgenden Schritte umfasst:
- Anlegen eines Spannungssignals (Csm) an die Wortleitung (WLm) des Speichers während des Ausführens der Operation an der Speicherzelle,
- Senden des Signals für das Ende der Operation (OP, OPm, /OP, /OPm) am Ende der Operation, bevor das Anlegen des Spannungssignals (Csm) an die Wortleitung des Speichers gestoppt wird, und anschließend Stoppen des Sendens des Signals für das Ende der Operation, nachdem das Anlegen des Spannungssignals an die Wortleitung des Speichers gestoppt wurde.

13. Verfahren nach einem der Ansprüche 11 und 12, wobei das Signal für das Ende der Operation für weniger als 20 Nanosekunden gesendet wird.

14. Verfahren nach einem der Ansprüche 11 bis 13, umfassend den Schritt des Nichtsendens des Signals für das Ende der Operation, wenn keine Operation an Speicherzellen ausgeführt wird, um einen transienten Impuls außerhalb der Zeiträume zu erfassen, in denen Speicherzellen verwendet werden.

## Claims

1. A memory (MEM1) comprising:
- a control circuit (CCT, HC) for executing read, write or erase operations on memory cells, and
- at least one word line (WLm) to which memory cells (MC) are coupled,
**characterized in that** the control circuit is configured to emit an end-of-operation logic signal (OP, OPm, /OP, /OPm) at the end of the execution of an operation on at least one memory cell,
and **in that** it comprises at least one circuit (DC, DC1, DC1', DC1", DC2, DC2', DC2", DC3) for detecting a non-authorized glitch that may be representative of a fault-injection attack, coupled to the memory word line (WLm), receiving the end-of-operation signal and configured to supply a glitch detection signal (DET, DETm, /DETm, GLT, GLTm, /GLTm) when a falling edge of the amplitude of a voltage signal (Csm) appears on the memory word line in the absence of the end-of-operation signal.

2. Memory according to claim 1, wherein the control circuit is configured to:
- during the execution of the operation on the memory cell, apply a voltage signal (Csm) on the memory word line (WLm),
- once the operation is over, emit the end-of-operation signal (OP, OPm, /OP, /OPm) before ceasing to apply the voltage signal (Csm) to the memory word line, then cease to emit the end-of-operation signal after ceasing to apply the voltage signal to the memory word line.

3. Memory according to one of claims 1 and 2, wherein the control circuit is configured to, once the operation is over, emit the end-of-operation signal for less than 20 nanoseconds.

4. Memory according to one of claims 1 to 3, wherein the glitch detection circuit (DC, DC1, DC1', DC1", DC2, DC2', DC2") comprises:
- detection means (C1, T1, T2, G3, G11) configured to transform a voltage signal (Csm) present on the memory word line (WLm) into a logic signal having a first logic value when the amplitude of the voltage signal is below a threshold and a second logic value when the amplitude of the voltage signal is above the threshold,
- storing means (C2, G1, G2, C11, G12, G13) for storing a switching of the logic signal from the first to the second logic value, and
- means (C3, G4, C12, G14) for supplying the glitch detection signal (DET, DETm, /DETm, GLT, GLTm, /GLTm) when the logic signal has the first logic value while the storing means have stored the switching of the logic signal to the second logic value, except if the end-of-operation signal is present.

5. Memory according to claim 4, wherein the storing means (C2, C11) are configured (T3) to be erased once the end-of-operation signal has been emitted.

6. Memory according to one of claims 1 to 3, wherein the glitch detection circuit (DC3) comprises:
- detection means (G21) configured to transform a voltage signal (Csm) present on the memory word line (WLm) into a logic signal having a first logic value when the amplitude of the voltage signal is below a threshold and a second logic value when the amplitude of the voltage signal is above the threshold, and
- a logic flip-flop (D1) configured to supply a glitch detection signal (/DETm, /GLTm) when the logic signal goes from the second to the first logic value.

7. Memory according to one of claims 1 to 6, wherein the glitch detection circuit comprises a glitch storage circuit (C4, C4', C13, C13') supplying a glitch detection signal (GLT, /GLT, GLTm) which persists after the end-of-operation signal has been emitted.

8. Memory according to one of claims 1 to 7, comprising a plurality of word lines and a plurality of glitch detection circuits (DC1", DC2", DC3) each coupled to a word line of the memory and each receiving the end-of-operation signal (OP, OPm, /OP, /OPm), and means for supplying a collective glitch detection signal (DET, GLT) that is a function of individual glitch detection signals supplied by the detection circuits.

9. Memory according to one of claims 1 to 8, wherein the control circuit is configured to emit the end-of-operation signal (OP, OPm, /OP, /OPm) at the end of an operation chosen among an operation of reading, writing, or erasing a memory cell.

10. Memory according to one of claims 1 to 9, wherein the control circuit is configured not to emit the end-of-operation signal (OP, OPm, /OP, /OPm) when it does not execute any operation on memory cells.

11. A method for monitoring a word line (WLm) of a memory (MEM1) susceptible of receiving a glitch that may be representative of a fault injection attack, the memory comprising memory cells (MC) coupled to the memory word line, and a control circuit (CCT, HC) for executing read, write or erase operations on memory cells,
method **characterized in that** it comprises the steps of:
- emitting an end-of-operation signal (OP, OPm, /OP, /OPm) by the control circuit (CCT, HC) at the end of the execution of a read, write or erase operation on at least one memory cell, and
- supplying a glitch detection signal when a falling edge of the amplitude of a voltage signal (Csm) appears on the memory word line in the absence of the end-of-operation signal.

12. Method according to claim 11, comprising the steps of:
- during the execution of the operation on the memory cell, applying a voltage signal (Csm) to the memory word line (WLm), and
- once the operation is over, emitting the end-of-operation signal (OP, OPm, /OP, /OPm) before ceasing to apply the voltage signal (Csm) to the memory word line, then ceasing to emit the end-of-operation signal after ceasing to apply the voltage signal to the memory word line.

13. Method according to one of claims 11 and 12, wherein the end-of-operation signal is emitted for less than 20 nanoseconds.

14. Method according to one of claims 11 to 13, comprising the step of not emitting the end-of-operation signal when no operation is executed on memory cells, to detect a glitch outside periods when the memory cells are used.
